# EUROPEAN PATENT SPECIFICATION

(11) **EP 1 426 999 B1**
(45) Date of publication and mention of the grant of the patent: **22.07.2009**
(21) Application number: 03027401.3
(22) Date of filing: 27.11.2003
(51) Int. Cl.: H01L 21/00

(54) **Thin plate storage container**
Behälter für dünne Platten
Conteneur pour plaques minces

(30) Priority: 02.12.2002 JP 2002349457; 13.02.2003 JP 2003035062
(43) Date of publication of application: 09.06.2004
(60) Divisional application: 08021842.3
(73) Proprietor: Miraial Co., Ltd., Tokyo (JP)
(72) Inventor: Matsutori, Chiaki C/O Kumamoto Plant,MiraialCo.LTD, Kikuchi-gun, Kumamoto-ken (JP); Oyama,Takaharu c/o Kumamoto Plant,MiraialCo.LTD, Kikuchi-gun, Kumamoto-ken (JP)
(74) Representative: Grünecker, Kinkeldey, Stockmair & Schwanhäusser Anwaltssozietät

(56) References cited:
- EP-A- 1 255 282
- WO-A-03/018434
- US-A1- 2002 005 369

## Description

### BACKGROUND OF THE INVENTION

This present invention relates to the thin plate storage container according to the preamble of claim 1.

For example, the transportable container to contain semiconductor silicon wafers inside and transport them is generally known from US 2002/0005369 A1. In such wafer container, it is important to keep its inside clean for preventing dirt and the like on the surface of contained semiconductor silicon wafer in transportation. For this purpose, the container is sealed tightly. In such case, usually a sealing member is placed on a lid of the container and the sealing member contacts with the container body to seal it when the lid closes the container body. The container of US 2002/0005369 A1 further comprises guides on the lid.

In addition, the thin plate storage container has a handle on each side of the container to be gripped to carry by hand.

Semiconductor silicon wafers are contained in the container having the above-mentioned structure to transfer them to a semiconductor manufacturing factory and the like.

Moreover, it is necessary that the wafer container supports semiconductor silicon wafers at regular intervals to keep them from contacting each other. Therefore supporting members are placed on both inside of the container body and on interior side of the lid to support semiconductor silicon wafers at regular intervals.

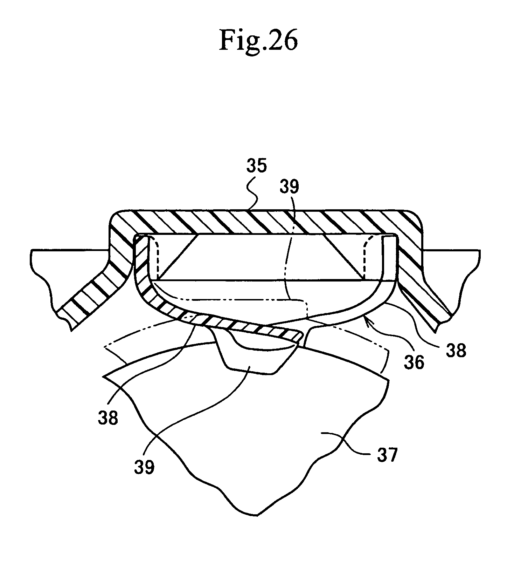

An example of a supporting member of the lid is illustrated in Fig.26. This supporting member was disclosed in the Japanese Patent Gazette (TOKUHYOHEI No.4-505263).

Reference No.35 in Fig.26 is an upper cover. Wafer holder 36 to support semiconductor silicon wafers from upper part was positioned as a supporting member on the inner side (lower side) of the upper cover 35. The semiconductor silicon wafers 37 stored in the container body (not illustrated) position below the upper cover 35.

The wafer holder 36 has supporting arm portions 38 alternately extending from right and left. Base end of the supporting arms 38 is fixed on the interior side of upper cover 35, and the other end extends toward the semiconductor silicon wafer 37. And a holddown member 39 at the tip of each of the supporting arm portions 38 is engaged with edge portion of the semiconductor silicon wafers 37 to support each semiconductor silicon wafer 37 at regular intervals.

Then the thin plate storage container of above-mentioned structure is lifted and lowered manually to transport and the like. In this case, a worker grips the handles to hold the thin plate storage container.

However, since the handles are placed on each of the sidewalls of the thin plate storage container, sidewalls are loaded when the thin plate storage container is lifted. Thereby an opening of the container body can be slightly distorted and the sealing member can be slightly slipped. In this case, although there is no problem about the sealing, it is not good for the aim for perfection.

Besides it, there is a slight gap between the container body and the lid when the container body is fitted with the lid. There is no problem in normal use of the thin plate storage container, but there is a possibility for the thin plate storage container to be shocked when the thin plate storage container is mounted. In this case, the lid can be slipped because of the gap between the container body and the lid and then the sealing member can be slipped. In this case, although there is not problem about sealing, it is not good for the aim of perfection.

Moreover, in the thin plate storage container having above-mentioned structure, each of the supporting arm portions 38 of the wafer holder 36 is cantilevered such that base end of the arm is fixed at the upper cover 35 and the top end is free. Thereby the supporting arm portions 38 hold the semiconductor silicon wafers 37 by comparatively weak force, and it is difficult to hold the semiconductor silicon wafer 37 by strong force. Therefore it is difficult to hold a kind of semiconductor silicon wafer 37 having large radius and heavy weight securely and there is a problem that the semiconductor silicon wafers 37 are shaken in the container.

Regarding the wafer holder 36 cantilevered, each of holddown member 39 of the wafer holder 36 rotates around its base portion, therefore if the semiconductor silicon wafers 37 slip, there is a problem that friction is caused between the holddown member 39 and the semiconductor silicon wafers 37 and then dust is generated.

### SUMMARY OF THE INVENTION

The aim of the present invention is to provide a thin plate storage container to prevent a lid from slipping.

The thin plate storage container according to claim 1 solves the above-mentioned problem and comprises the features defined in claim 1.

Owing to above-mentioned structure, the lid supporters at the lid receptacle of the container body and the contacting portions on the periphery of the lid contact directly or through a slight gap when the lid is placed at the lid receptacle of the container body. In this state, if the container body is shocked by careless handling of the thin plate storage container, the lid supporters and the contacting portions contact directly to hold the lid, without slip of the lid from the container body.

It is preferable that each of the lid supporters is formed as a convex dovetail to engage with a dovetail groove placed at the lid receptacle, and that a plane contacting surface is placed on the surface of each of the lid supporters.

Owing to above-mentioned structure, contacting surfaces of the lid supporter, protruding and dovetailed, contact with the contacting portions in condition that the lid supporters engage with the concave dovetail grooves. Generation of dust and the like can be kept to the minimum because each contacting surface is designed as plane. In this case, materials of lid supporters and contacting portions are selected from a combination of materials so that dust generation is kept to the minimum when they are frictionized each other.

It is preferable that each of the contacting portions comprises a fixing plate portion to be inserted into and fixed on an engagement groove placed at a corner of periphery of the lid, and the contacting plate portion curved to a corner of the lid in condition that the contacting plate portion is supported by the fixing plate portion and outside of the contacting plate portion is a plane contacting surface to contact the lid supporter.

Owing to above-mentioned structure, the contacting plate portion is positioned to cover a corner of the lid in condition that the fixing plate portion is fixed on the engagement groove at the corner of the lid. In this condition, the contacting surface, plane and near both ends of the contact plate, contacts with the lid supporter to support the lid. Thereby the lid scarcely slips when the container body is shocked, thereby sealing quality is improved.

The thin plate storage container of the present invention further comprises the container body, to store and hold the plurality of thin plates in condition that inside of the container body is kept clean, and the lid to close and seal inside of the container body. The thin plate storage container, can comprise a supporting member placed to the container body, and the supporting member further comprises a base plate portion placed at a lower end wall of the container body, lying broadwise, to support the container body, the side plate portions standing at both side of the base plate portion, and handles placed at the side plate portions to be gripped to lift the container body.

Owing to the above-mentioned structure, the handles are gripped to lift the thin plate storage container. When these handles are gripped and lifted, the supporting member is held directly, and then the container body is supported by the base plate portion. Thereby distortion caused by lifting of handles is absorbed by the side plates of the supporting member and the base plate portion, so that the effects on the container body is minimized.

It is preferable that detents are placed on both side plate portions of said container body.

Owing to above-mentioned structure, the container body can be supported more securely by the supporting members by engaging of the detents of both sidewalls of the container body with the side plate portions of the supporting member.

It is preferable that conveyor rails are placed on the side plate portions of the supporting member.

Owing to above-mentioned structure, the thin plate storage container can be transferred by hanging the conveyor rails on a conveyor of a production line and the like of factories without any attachment and modification.

It is preferable that a positioning means is placed on the base plate portion of the supporting member to adjust the mounting position of the container body precisely.

Owing to above-mentioned structure, the mounting position of the container body can be precisely adjusted by the positioning means.

The thin plate storage container of the present invention can further comprise the container body to store and support the plurality of thin plates in condition that inside of the container body is kept clean, and the lid to close and seal the container body, and the container further can comprise a thin plate supporting member placed on inner side of the lid to support the thin plates at regular intervals. The thin plate supporting member comprises contacting portions to engage with the periphery of each of the thin plates to support, supporting portions to support the contacting portions elastically, and a base supporting bar portion placed inside of the lid to integrally support all of the plurality of the supporting portions aligned parallel at regular intervals. Each base of the supporting portions is integrally connected with the base supporting bar portion, and the contacting portions are placed on the midway of the supporting portions, and the tip of the supporting portions contact with inner side of the lid to support the contacting portions from both sides elastically.

Owing to above-mentioned structure, thin plates having large diameter and heavy mass can be held securely because the supporting portions support the contacting portions from both sides elastically.

It is preferable that base side of each supporting portions is formed long, and tip side is formed short.

Owing to above-mentioned structure, the supporting portions support the contacting portions in condition that the base supporting bar portion is placed on the inner side of the lid and the base of the base supporting bar portion is fixed on the lid. In this case, since the distance between the base supporting bar portion and each of the contacting portions is formed long, the supporting portions push the lid supporters to the periphery of the thin plate with weak force when each of the contacting portions contacts with each periphery of the thin plates. In addition, when each tip side of the contacting portions in the supporting portion contact with the inner side of the lid, the contacting portions are elastically supported from both sides. Then the contacting portions are pushed toward the periphery of the thin plates with strong force since the tip sides from the contacting portions are formed short. Although there is no difference of elastic coefficient between both sides of each contacting portions, the supporting portions support the contacting portions with strong force since the tip sides are short.

It is preferable that the supporting portions are formed as elevating at both sides of the contacting portions toward the thin plates within the container body.

Owing to above-mentioned structure, the rising and leaning parts exert a strong elastic force since both sides of the supporting portions are elevated toward the thin plates within the container body.

It is preferable that supporting stages are placed on inner side of the lid to support the tip side of the supporting portions.

Owing to above-mentioned structure, the supporting portions are supported from both sides by that the supporting stages being placed on the inner side of the lid support the tip of the supporting portions. Therefore the contacting portions are supported by the supporting portions from both sides of the contacting portions.

It is preferable that engagement portions to engage with and support the tip side of the supporting portions are placed on the supporting base.

Owing to above-mentioned structure, the tip of each of the supporting portions is supported securely by engagement of the tip of the supporting portions with the engagement portions of the supporting stages. Therefore the contacting portions are supported by the supporting portions stably.

It is preferable that supporting stage portions are placed on the tip of the supporting portions to contact with the inner side of the lid to support the contacting portions elastically from the tip side.

Owing to above-mentioned structure, the contacting portions are elastically supported by contact of the supporting stage portions with the inner side of the lid.

The thin plate supporting member is placed as opposing each other and the contacting portions are aligned as opposing and sandwiching each other to support the thin plates at regular intervals.

Owing to above-mentioned structure, a plurality of thin plates can be supported at regular intervals.

### BRIEF DESCRIPTION OF THE DRAWINGS

Fig. 1 is a partial perspective view showing a main part of a container body of a wafer storage container according to the claimed invention.
Fig. 2 is a perspective view showing a container body of a wafer storage container.
Fig. 3 is a front view showing a lid supporter.
Fig. 4 is a side view showing the lid supporter.
Fig. 5 is a top view showing the lid supporter.
Fig. 6 is a rear view showing the lid supporter.
Fig. 7 is a perspective view showing a modified lid supporter.
Fig. 8 is a perspective view showing a main part of the lid.
Fig. 9 is a perspective view showing the lid.
Fig. 10 is a perspective view showing a contacting portion.
Fig. 11 is a top view showing the contacting portion.
Fig. 12 is a perspective view showing a supporting member.
Fig. 13 is a perspective view showing the wafer storage container.
Fig. 14 is a top view showing the wafer storage container.
Fig. 15 is a perspective view showing a main part of the wafer storage container.
Fig. 16 is a perspective view showing a detent.
Fig. 17 is a perspective view from above, showing a thin plate supporting member of a thin plate storage container according to the second example of a storage container.
Fig. 18 is a perspective view showing a container body of the thin plate storage container according to the second example of a storage container.
Fig. 19 is a perspective view showing a lid of the thin plate storage container according to the second example of a storage container.
Fig. 20 is a perspective view from below showing a thin plate supporting member of the thin plate storage container according to the second example of a storage container.
Fig. 21 is a side view showing the thin plate supporting member of the thin plate storage container according to the second example of a storage container.
Fig. 22 is a perspective view showing a strip projection of the lid of the thin plate storage container according to the second example of a storage container.
Fig. 23 is a perspective view showing the thin plate supporting member of the thin plate storage container according to the second example of a storage container.
Fig. 24 is a side view showing the first modification of the second example of a storage container.
Fig. 25 is a side view showing the second modification of the second example of a storage container.
Fig. 26 is a sectional view of a main part of a thin plate supporting member of prior art.

The second example of the storage container is not part of the claimed invention.

### DESCRIPTION OF THE PREFERRED EMBODIMENT

Hereinafter, the present invention will be described by way of two examples with reference to the attached drawings.

First, the first example being the embodiment of the invention is explained. In this embodiment, a storage container to store and transport semiconductor silicon wafers as thin plates is given as an example.

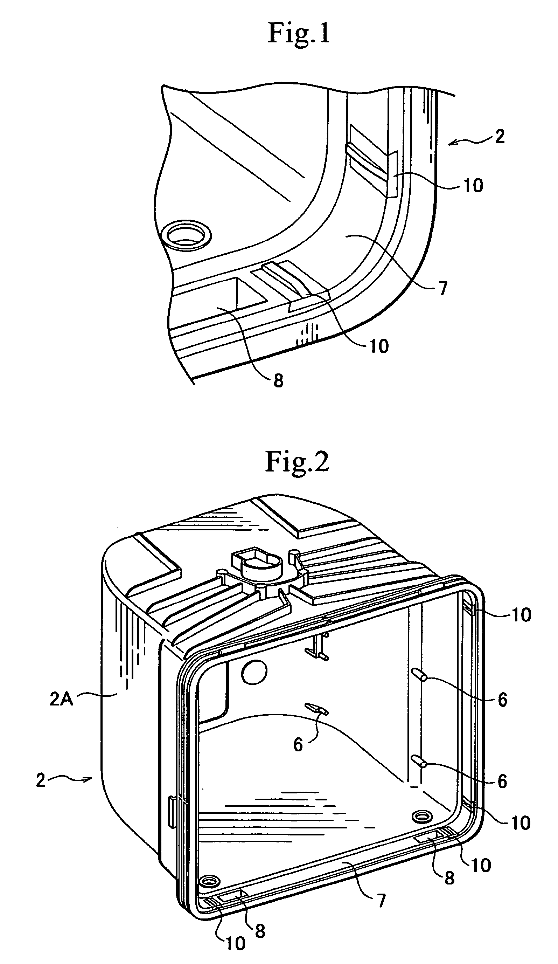

This wafer storage container 1 comprises, as shown in Fig. 2, 9, and 13, a container body 2 to support a plurality of semiconductor silicon wafers (not shown) within the container body 2, wafer supporting plates (not shown) placed on the two sidewalls inside of this container body 2 facing each other to support a plurality of semiconductor silicon wafers, stored inside parallel and at regular intervals, from both sides of the wafer, a lid 3 to seal the upper opening of the container body 2 and to keep its inside clean, and a supporting member 4 to support the container body 2.

The container body 2 is formed as generally cube. For supporting detachable wafer supporting plates, a plurality of supporting protrusions 6 are placed on rear side and back side, inside of sidewall portions 2A and 2B of the container body 2. A lid receptacle 7 is placed on an upper opening of the container body 2 to engage with the lid. This lid receptacle 7 is formed by extending the upper opening of the container body 2 to meet the diameter of the lid.

Engagement bores 8 are placed on the lid receptacle 7 to engage with later mentioned stop rollers 14 of the lid 3. These engagement bores 8 are placed around each of four corners.

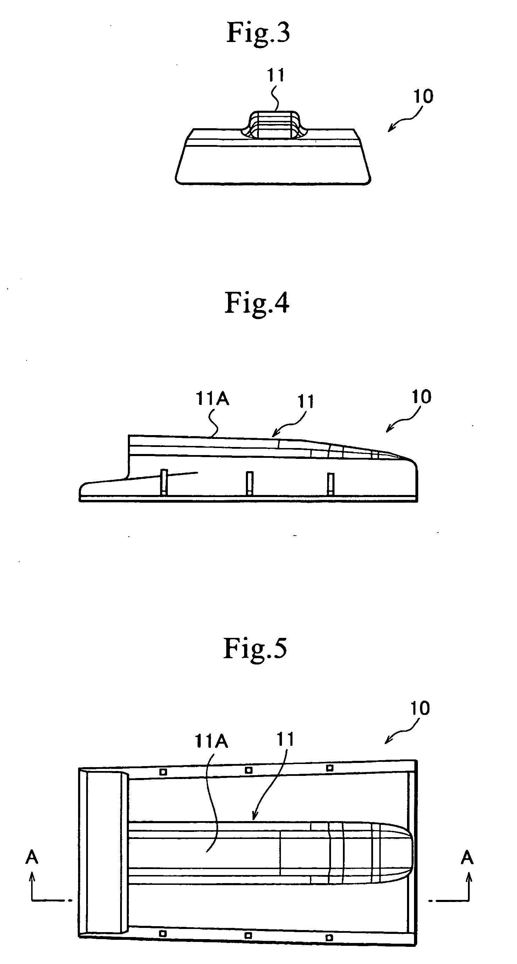

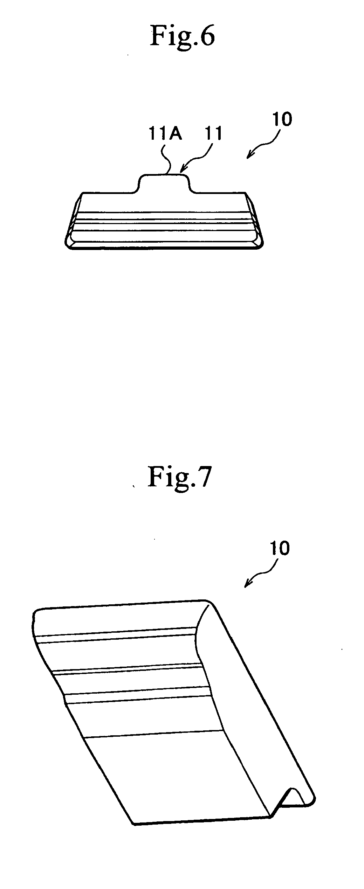

Lid supporters 10 are placed on each four corners of the lid receptacle. Lid supporters 10 are, as shown in Fig. 1-6, formed like wedges having dovetail on both sides to engage dovetail grooves placed on the lid receptacle 7. At the center surface of each lid supporter 10, a protruding line 11 is placed over entire length of the lid supporter. A taper is placed on the outside of the protruding line 11 (right side of Fig. 4) to prevent contacting with contacting portions 16 when the lid 3 is placed and detached. Rear side of the protruding line 11 is a contacting surface 11A. This contacting surface 11A is a part to contact with a contacting portion 16, and is formed as flat. If there is a taper on the contacting surface 11A, uneven contacting pressure is caused on all range of contacting surface, and then dust is generated. Besides it, although the contacting surface 11A is narrow because of the configuration of the protruding line 11, the area of the contacting surface 11A is set according to the balance between load and friction. It is preferable that the contacting surface 11A is designed as narrow as possible since there is a possibility of conflict caused by contact between the contacting portion and the lid supporter 10 when the lid 3 is attached and detached. On the other hand, the protruding line 11 must support the weight of the lid 3. For this reason, the area of the contacting surface 11A is minimalized according to the balance with the weight of the lid 3. If the lid 3 is a large and heavy one, to broaden its contacting area, the installation of the protruding line 11 can be omitted like in Fig. 7.

A pair of lid supporters 10 is placed at each four corners of the lid receptacle 7. In particular, the pair of lid supporters 10 is placed by engaging with a pair of dovetail groove on each of four corners of the lid receptacle 7, and then each pair of the lid supporters 10 at each corner of the lid receptacle 7 supports each corner of the lid 3 squarely.

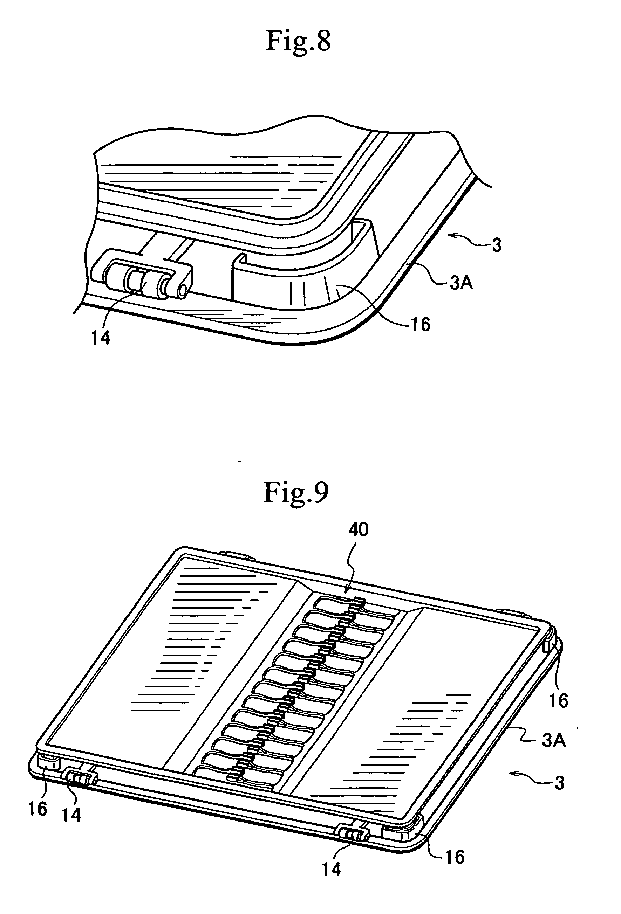

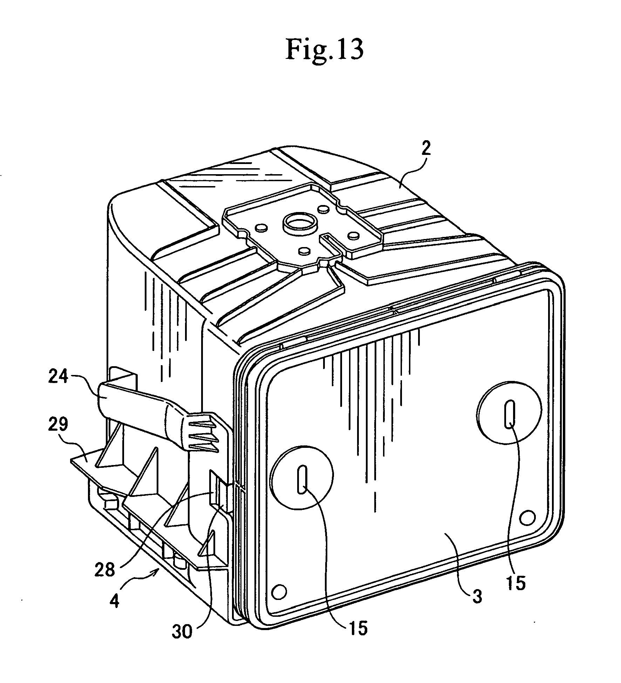

The lid 3 is, as shown in Fig. 8 and 9, formed as a thick quadrangular plate and engaged with the lid receptacle 7 of the container body 2. A flange portion 3A is placed on outer side of the lid 3 (lower part of Fig. 9) to cover the outside of the lid receptacle 7 in condition that the lid 3 engages with the lid receptacle 7. The stop roller 14 is placed around each corner of the lid 3 in condition that the stop roller 14 can rise and set freely. On the surface of the lid 3, a pair of key openings (shown in Fig. 13) is placed to rise and set each stop roller 14 freely. The stop roller 14 connected by a link (not shown) is risen to engage with an engagement bore 8 by insertion and rotation of the key. The key is placed on an arm of a transport mechanism in a production line or the like, and then the lid 3 is automatically set and detached. A sealing member (not shown) is placed on the inside periphery of the lid 3.

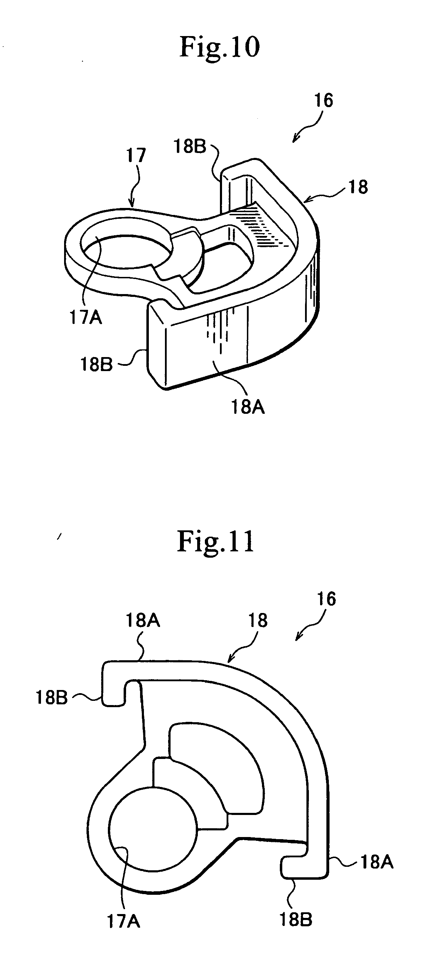

Contacting portions 16 are placed on each corner of the lid 3. These contacting portions 16 are members to contact with the lid supporters 10 of the container body 2 to support the lid 3. Each of the contacting portions 16 is constructed by a fixing plate portion 17 and a contacting plate portion 18, as shown in Fig. 10 and 11. The fixing plate portion 17 has a shaft hole 17A, and the fixing plate portion 17 is inserted into a contacting groove (not shown) on each corner of the periphery of the lid 3 to fix. The contacting plate portion 18 is formed as curve to cover each corner of the lid 3 in condition that the contacting plate portion 18 is supported by the fixing plate portion 17. Both sides of outer surface of the contacting plate portion 18 are formed as a flat contacting surface 18A to contact with the contacting surface 11A of the lid supporters 10. Support leg portions 18B are placed on both sides of the contacting plate portion 18. These support leg portions 18B are formed by bending both sides of the contacting plate portion 18 inward to support the contacting surface 18A by contacting with a peripheral wall of the lid 3, in condition that the contacting plate portion 18 is placed on the corner of the lid 3. The contacting surface 18A supported by this support leg portion 18B contacts with the contacting surface 11A of the lid supporter 10 to support the lid 3, therefore if the container body 2 is shocked, the lid 3 does not slip.

The materials of the lid supporter 10 and the contacting portion 16 must be chosen from the materials that generate little dust when frictionized with each other. In particular, PBT (polybutylene terephthalate) resin, PEEK (polyether ether keton) resin, polyacetal resin, supermacromolecular PE (polyethylene) resin, or nylon resin is used for the material of the lid supporter 10. Alternatively, the materials that PTFE (polytetrafluoroethylene) and/or carbon fiber is added to these five materials are suitable, too. As well as the lid supporter 10, 15 kinds of materials, such as PBT resin, PEEK resin, polyacetal resin, supermacromolecular PE resin, nylon resin, and the materials that PTFE and/or carbon fiber is added to these five materials, are suitable for the contacting portion 16. Suitable pair of these materials that generate little dust when frictionized is used.

On the rear side of the lid 3, there is a thin plate supporting member 40. Concrete structure of the thin plate supporting member 40 is detailed below.

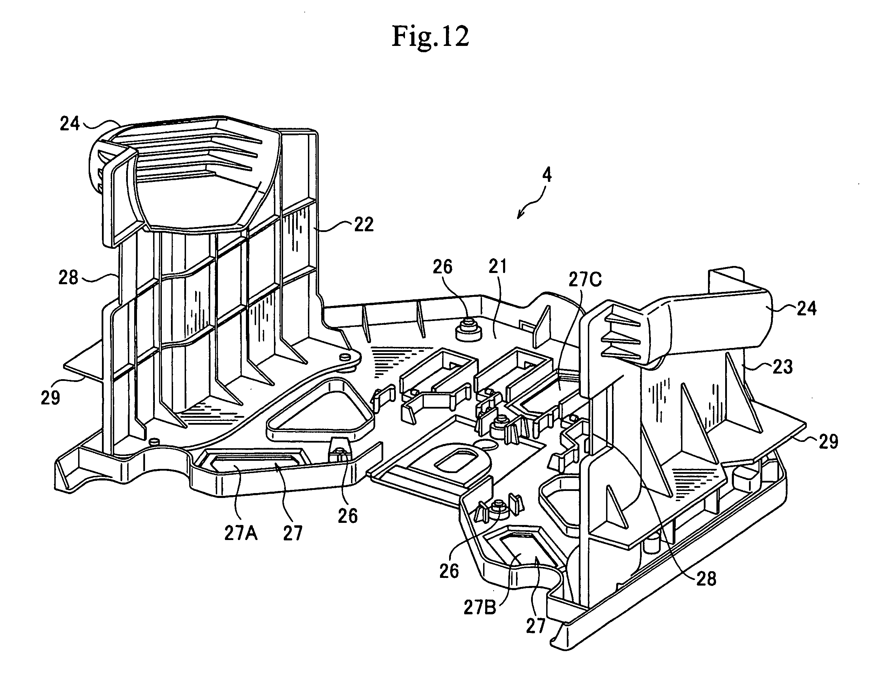

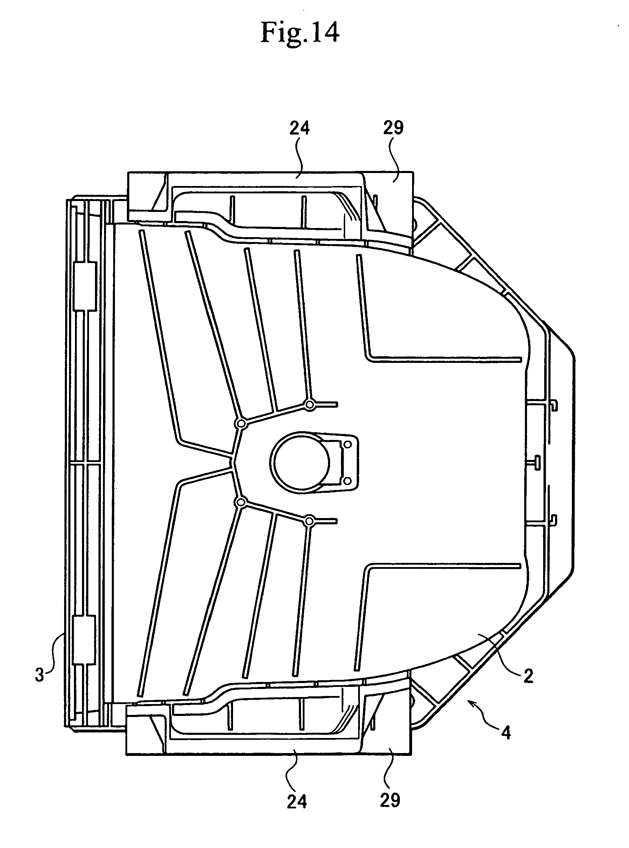

A supporting member 4, not being the claimed invention, is a member to support the container body 2. This supporting member 4 comprises, as shown in Fig. 12-16, a base plate portion 21, sidewalls 22 and 23, and handles 24.

The base plate portion 21 is a plate material to support the container body 2 directly. The base plate portion 21 is placed on the lower end of the container body 2 (lower part in Fig. 13) laid on its side to support the container body 2. The supporting member 4 and the container body 2 are fastened each other by screw in condition that a plurality of supporting bars 26, placed on the surface of the base plate portion 21, supports the container body 2. In addition, positioning engagement portion 27 as positioning means are placed on the base plate portion 21 to adjust the mounting position of the thin plate storage container. This storage container consists of three engagement portions, 27A, 27B, and 27C. Each of the three engagement portions, 27A, 27B, and 27C, consist of a V-shaped groove. The angle between long axis of each engagement portions, 27A, 27B, and 27C is generally 120°, and the three engagement portions are placed toward different three directions. The dimension, angle and the like of the positioning engagement portion 27 have been standardized. There are three engagement protrusions (not shown) at positions corresponding to the position of each of the engagement portions, 27A, 27B, and 27C, on the area that the container body 2 is mounted. These engagement protrusions control the position of the container body 2 precisely by engaging each of the engagement portions 27A, 27B, and 27C.

Side plate portions 22 and 23 are formed as standing from the both side of the base plate portion 21. There are handles 24, detent receptacle portions 28, and conveyor rails 29 on the side plates 22 and 23. The handles 24 are member to be held to lift the container body 2. The handles 24 are formed as integral with the upper ends of the side plates 22 and 23. The finger receptacle portions 28 are placed on the forward edges of the side plates 22 and 23 (near edge of Fig. 12). The finger receptacle portions 28 are formed by that the side plates 22 and 23 are thinned and hollowed to engage detents 30.

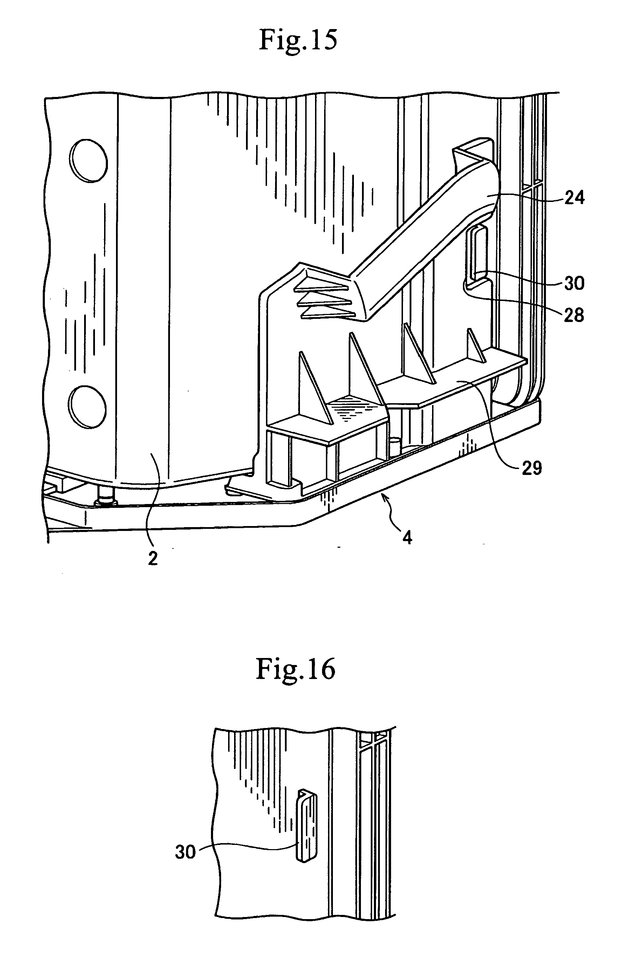

The detents 30 are members to support the supporting member 4 onto the container body 2 securely by engaging with the detent receptacle portions 28 securely to prevent the side plates 22 and 23 from opening. The detents 30 are placed on the forward of the side plates 2A and 2B of the container body 2 (right hand of Fig. 15). The surface of the detents 30 are L-shaped so that the detents 30 engage with the detent receptacle portions 28 of each side plate 22 and 23.

The conveyor rails 29 are placed on the outside of each side plate 22 and 23. Conveyor rails are the members to be hanged and to be carried by conveyors of production line or the like of a factory. The conveyor rails 29 are made of flat plate material and horizontally aligned outside along the entire length of longitudinal direction of each side plate 22 and 23.

Reinforcement ribs are placed lengthwise and crosswise on the base plate portion 21 and side plate portions 22 and 23 to reinforce entire body.

The wafer storage container 1 structured as above is used as below.

Firstly, semiconductor silicon wafers are stored in the container body 2 and then the lid 3 is placed. Thereby the lid supporters 10 on the lid receptacle 7 of the container body 2 and the contacting portions 16 of the lid 3 directly contact each other, or contact through a slight gap. The wafer storage container 1 is then conveyed to its destination in this state.

During this conveyance, if the container body 2 is shocked by careless handling and the like, the lid supporters 10 contact with the contacting portions 16 directly to support the lid 3. Then the slip of the lid 3 from the container body 2 is prevented.

Generation of dust and the like is minimalized because the lid supporters 10 and the contacting portions 16 are made by PBT resin, PEEK resin, polyacetal resin, supermacromolecular PE resin, or nylon resin, and each contacting surface, 11A and 18A, is formed as flat.

The handles 24 are held and lifted to carry the wafer storage container 1. Holding the handles 24 and lifting the wafer storage container 1 becomes holding the supporting member 4 directly, and then the container body 2 is supported by the base plate portion 21. In this time, the side plate portions 22 and 23 are supported without being opened since the latch fingers 30 on the sidewall portions 2A and 2B of the container body 2 engage with the finger receptacle portions 28 on the side plate portions 22 and 23 of the supporting member 4, and when the handles 24 are held to lift the wafer storage container 1, the side plate portions 22 and 23 are stabilized without vacillation. Distortion and the like generated when the handle 24 is held is absorbed by the side plates 22 and 23 of the supporting member 4, and the base plate portion 21, and then the effect on the container body 2 is minimalized. Therefore the effect on the sealing member between the container body 2 and the lid 3 is prevented.

In production lines and the like of each factory, the conveyor rails 29 are hanged by a conveyor to transport the container. In addition, the positioning engagement portions 27 control the position of the container body 2 precisely when the container is mounted on a mounting stand.

As above, if the container body 2 is shocked, the lid supporters 10 and the contacting portions 16 directly contact each other and the lid is supported without slip from the container body 2 because the lid supporters 10 are placed on the container body 2 and the contacting portions 16 are placed on the lid 3. Moreover, slip of the sealing member between the container body 2 and the lid 3 is prevented and then the sealing quality of the wafer storage container 1 is more improved.

Generation of dust and the like is minimalized because the contacting surface 11A of each lid supporter 10 and the contacting surface 18A of the contacting portion 16 are formed as flat and the material of each contacting surface is carefully selected.

Deviation and the like generated when the wafer storage container 1 is lifted is absorbed by the side plate portions 22 and 23 of the supporting member 4 and the base plate portion 21 since the handles 24 are placed on the supporting member 4, and then the effect on the container body is minimalized and thereby the sealing quality is improved.

Engagement between the detents 30 on the container body 2 and the detent receptacles 28 on the side plate portions 22 and 23 of the supporting member 4 prevents the side plates 22 and 23 from opening, and then the container body 2 is supported more securely.

The conveyor rails 29 are placed on the side plate portions 22 and 23, therefore the container is conveyed by hanging the rail on the conveyor of production line and the like in each factory, without any attachment or modification.

The mounting position of the container body 2 is precisely adjusted since the positioning engagement portion 27 is placed on the base plate portion 21.
(1) Although the lid supporters 10 and the contacting portions 16 are placed on each of four edges of the lid receptacle 7 of the container body 2 in the above-mentioned first embodiment, the lid supporters 10 and the contacting portions 16 can be also placed only on lower edge or lower edge and both edge of the laid container. In these cases, the same effect as above-mentioned embodiment is given when the laid container is handled. The lid supporters 10 and the contacting portions 16 can be placed on all of the four edges of the lid receptacle or one edge only according to the using condition.
(2) It is enough that the base plate portion 21 and the side plates 22 and 23 of the supporting member 4 are formed that they can support the container body 2 and can set the handles 24, so various shapes, not only flat shape, can be adopted for them.

A second example, not being part of the claimed invention, but providing background information is explained with reference to the attached drawings.

In this example, a storage container to store and carry thin-plate semiconductor silicon wafers as thin plates is taken for instance.

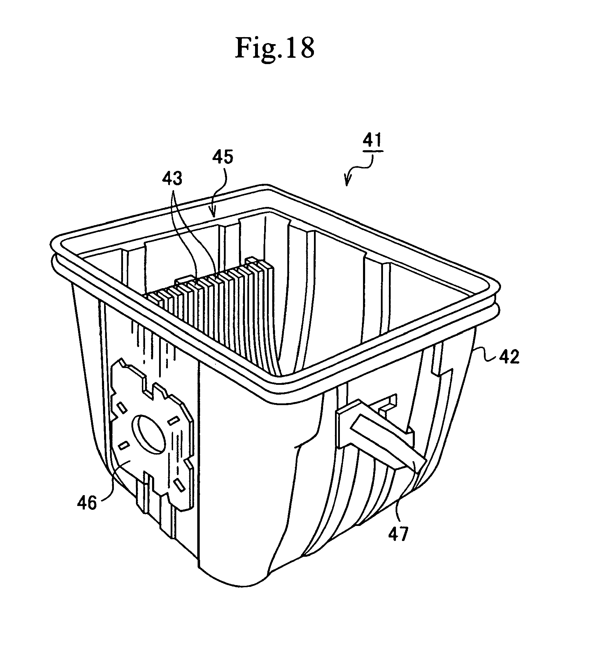

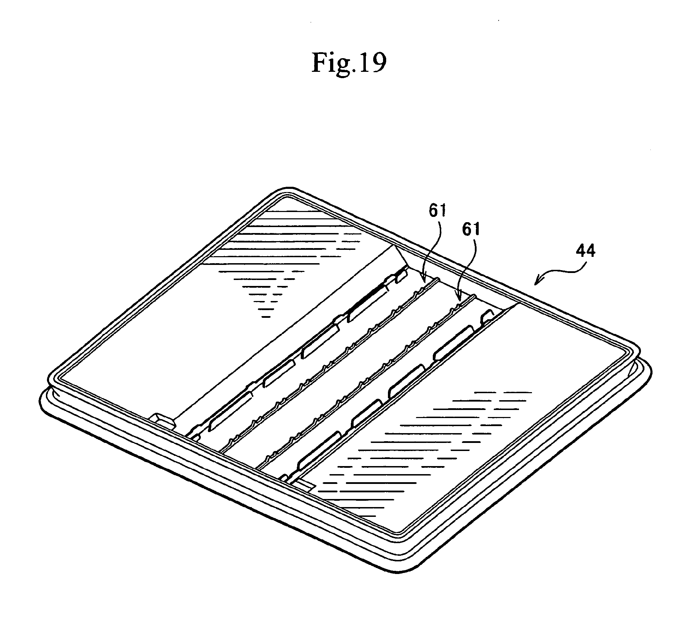

This wafer storage container 41, as shown in Fig. 18 and Fig. 19, comprises a container body 42 to store a plurality of semiconductor silicon wafers (not shown) within it, wafer supporting plates 43 placed on opposite side walls in the container body 42 to support a plurality of semiconductor silicon wafers from both sides of the wafers, which stored within the container body, parallel and at regular intervals, and a lid 44 to seal an upper opening of the container body 44 and to keep the container's inside clean.

A lid receptacle 45 is placed on upper part of the container body 42 to engage with the lid 44. This lid receptacle 45 is formed by enlarging the upper end of the container body 42 to meet the dimension of the lid. Various fixing means (not shown) are placed between the lid 44 and the lid receptacle 45 to fix the lid 44 onto the container body 42.

Reference No. 46 in Fig. 18 is a carrier flange part to be held by an arm of a carrier mechanism (not shown) of a production line when the container is carried. Reference No. 47 is a handle for a worker to carry the container or to lift and lay along by hand.

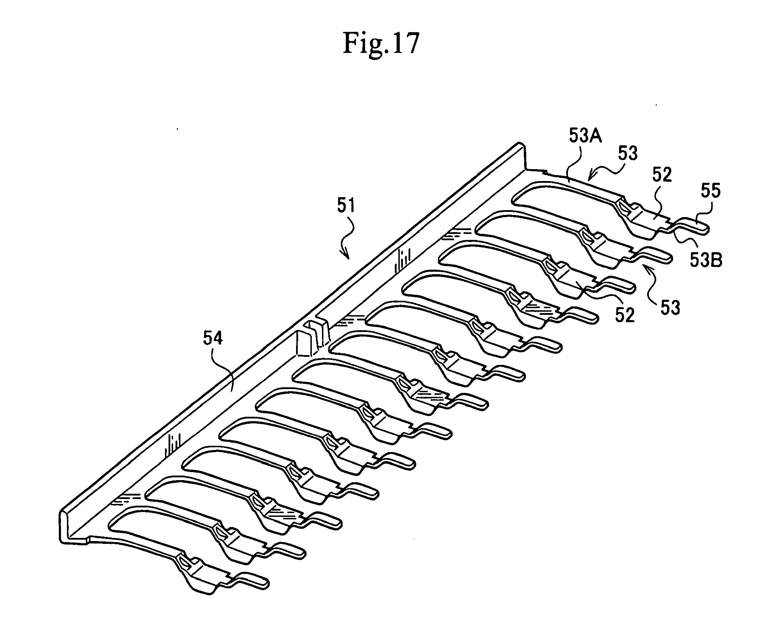

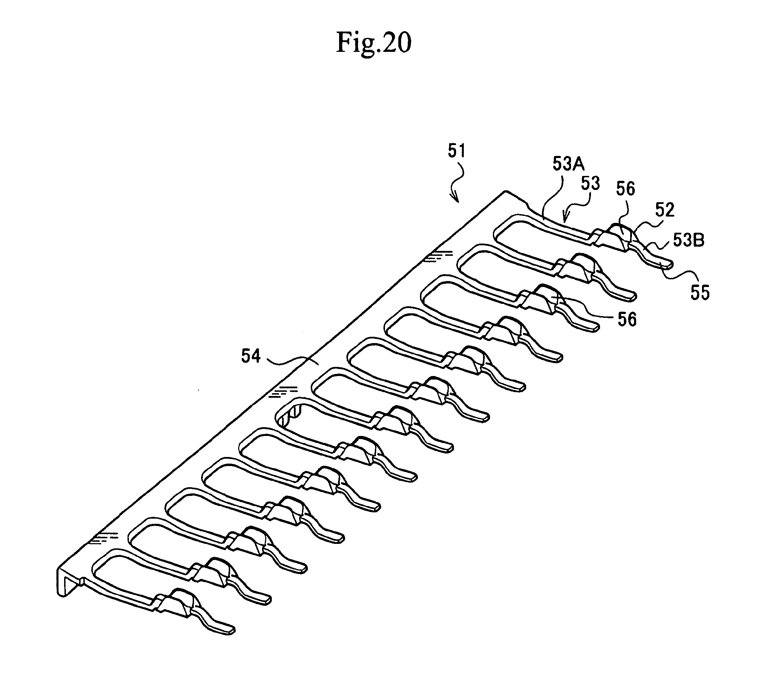

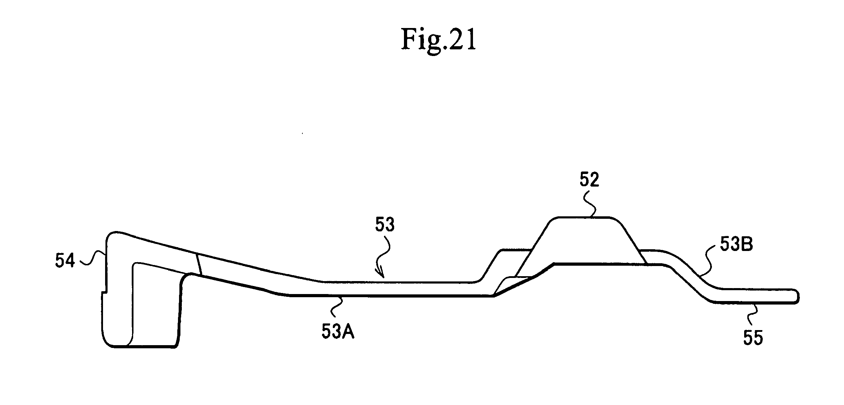

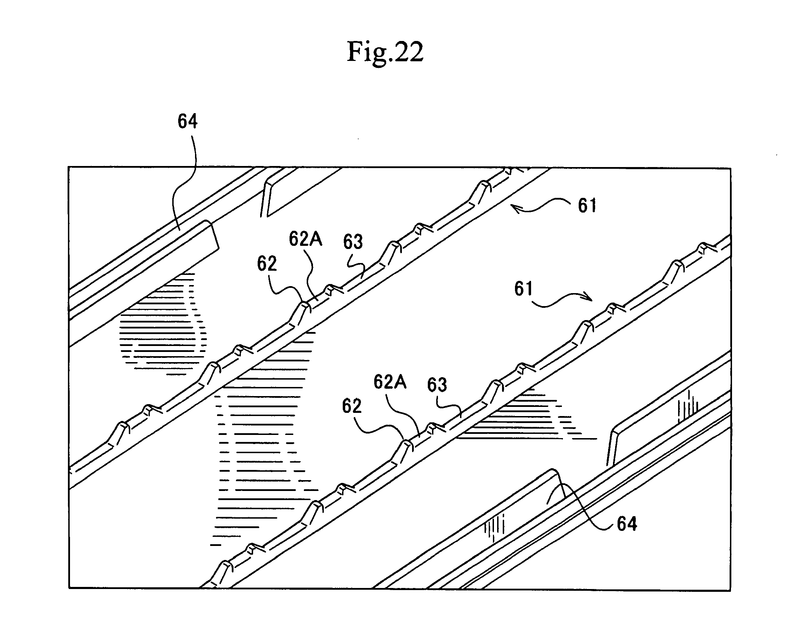

Thin plate supporting member 51 is placed on inner side of the lid 44 (upper side in Fig. 19). The thin plate supporting member 51 has members to support each of stored semiconductor silicon wafers from their upside at regular intervals. The thin plate supporting member 51 is explained according to Fig. 17 and Fig. 19-23.

The thin plate supporting member 51 mainly comprise contacting portions 52 to engage with periphery of semiconductor silicon wafers and to support the semiconductor silicon wafers, supporting portions 53 to support the contacting portions elastically, and a base supporting bar portion 54 placed on inner side of the lid 44 (upper side of Fig. 19) to support a plurality of the supporting portions 53 parallel, integrally and at regular intervals.

Engagement grooves 56 are placed on the side of the contacting portions 52 on the side opposite to the semiconductor silicon wafers. These engagement grooves 56 are the members that engage with the periphery of the semiconductor silicon wafers to support the wafers. The supporting portions 53 are integrally placed on both sides of the contacting portions 52.

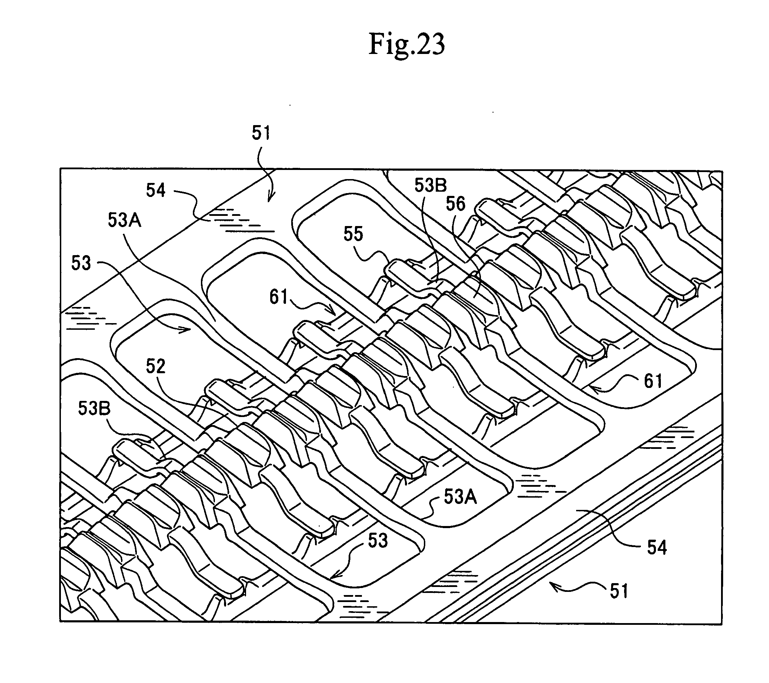

The supporting portions 53 are members that are formed integral with the contacting portions 52 to support them. The supporting portions 53 are formed like rod, and made of elastic synthetic resin, and support the contacting portions 52. The contacting portions 52 are placed on the halfway of the supporting portions 53. Therefore the contacting portions 52 forms boundaries between base supporting portions 53A and tip supporting portions 53B of the supporting portions 53. Each base part of the tip supporting portions 53B is formed as integral with the contacting portions 52. Caul plate portions 55 are formed at the end of the tip supporting portions 53B. The caul plate portions 55 engage with below-mentioned engagement portions 62A of supporting stages 62 (as shown in Fig. 23) to support the tip supporting portions 53B. Thereby the contacting portions 52 are elastically supported by the base supporting portions 53A and the tip supporting portions 53B from both sides.

The base supporting portions 53A are formed long, and the tip supporting portions 53B are formed short. Since the base supporting portions 53A are formed long, the base supporting portions 53A press the contacting portions 52 on the periphery of the semiconductor silicon wafers with weak force at first when the contacting portions 52 contact with the periphery of the semiconductor silicon wafers. Then, since the tip supporting portions 53B are formed short, the caul plate portions 55 at the end of the tip supporting portions 53B contact with the inner surface of the lid 44, and support the contacting portions 52 with strong force. Thereby the contacting portions 52 are pressed on the periphery of the semiconductor silicon wafers with strong force.

Depending on situations, gaps having predetermined width are given between the tip supporting portions 53B and the engagement portions 62A of the supporting stages 62. If the gaps are given, the contacting portions 52 are supported by only the base supporting portions 53A from one side to support the semiconductor silicon wafers with weak force, in condition that the contacting portions 52 contact with the periphery of the semiconductor silicon wafers. In addition, if the semiconductor silicon wafers are shaken hardly by external force such that the wafer storage container 41 is swung and the like, the contacting portions 52 are pushed and thereby the tip supporting portions 53B contact with the engagement portions 62A of the supporting stages 62 to support the semiconductor silicon wafers elastically from both sides of the wafers with strong force. On the other hand, if the gaps are not given, the semiconductor silicon wafers are supported with strong force from the start.

In the supporting portions 53, both sides of the contacting portions 52 are formed by protruding the contacting portions 52 to the direction of semiconductor silicon wafers stored in the container body 42. Slant parts of the supporting portions 53 slanted by protruding enforce the elastic force of the supporting portions 53.

Base supporting bar portions 54 are members to support each supporting portion 53 parallel and at regular intervals. These base supporting bar portions 54 support each supporting portion 53 and engage with below-mentioned supporting grooves 64 to be fixed on inner side of the lid 44.

There are strip projections 61 on inner side of the lid 44. These strip projections 61 are members to support the tip of the supporting portions 53. The strip projections 61 are structured by supporting stages 62 and supporting recesses 63 aligned alternately. Two supporting recesses 63 are placed parallel on the inner side of the lid 44. This structure is for supporting each caul plate portion 55 of oppositely placed two thin plate supporting members 51. The supporting stages 62 and the supporting recesses 63 of each strip projection 61 are placed as shifting from each other. Namely, the supporting stages 62 and the supporting recesses 63 are placed as opposing each other.

The supporting stages 62 of the strip projections 61 are members to support the caul plate portions 55 on the tip of the supporting portions 53. The engagement portions 62A are placed on the supporting stages 62. These engagement portions 62A are parts to engage with the caul plate portions 55 on the tip of the supporting portions 53 and to support the caul plate portions 55. The engagement portions 62A are formed as recess to support the caul plate portions 55 and prevent rightward and leftward slip.

The supporting recess portions 63 are members to engage and support the base supporting portions 53A. The supporting recess portions 63 are formed lower than the supporting stages 62. The height of the supporting recess portions 63 is set optimally according to each using situation. If a user wants to support the semiconductor silicon wafers with strong force, use the supporting stages 62 and the supporting recess portions 63 to support the wafers. Therefore the height of the supporting recess portions 63 should be set as that the base supporting portions 53A can contact with the supporting recess portions 63. On the other hand, if a user does not wants to support the wafers with strong force, use the base supporting bar portions 54 and the supporting stages 62 to support the wafers. Therefore the height of the supporting recess portions 63 should be set as that the base supporting portions 53A do not contact with the supporting recess portions 63.

In outside of the two strip projections 61, there are the supporting grooves 64 to engage with and support the base supporting bar portions 54 of the thin plate supporting member 51. The supporting grooves 64 are formed as grooves having diameter to engage with the base supporting bar portions 54. Two base supporting bar portions 54 of the thin plate supporting member 51 opposing each other engage with these two supporting grooves 64, and thereby the contacting portions 52 of two thin plate supporting members 51 are aligned as opposing and sandwiching each other to support each semiconductor silicon wafers at regular intervals. The two thin plate supporting members 51 have the same structure, and are placed oppositely.

The thin plate storage container structured as above is used as follows.

At first, a plurality of semiconductor silicon wafers is stored inside the container body 42. Each of semiconductor silicon wafers is supported by the wafer supporting plates 43 at regular intervals.

In this condition, the lid 44 is placed at the lid receptacle 45 of the container body 42. Thereby the contacting portions 52 of the thin plate supporting member 51 engage with and support each semiconductor silicon wafer.

In condition that the contacting portions 52 contact with the wafers, if the lid 44 is placed deeply into the lid receptacle 45, the contacting portions 52 are pushed up toward the inner side of the lid 44. Thereby the base supporting portions 53A, supported by the base supporting bar portion 54 which is fixed on the supporting groove 64, contacts with the contacting portions 52 with weak force, and then support each semiconductor silicon wafer. Otherwise, the caul plate portions 55 of the supporting portion 53 engage with the engagement portions 62A of the supporting stages 62 and support the contacting portions 52 from both sides, and then each semiconductor silicon wafer is supported with strong force. More otherwise, the base supporting portions 53A contact with the supporting recesses 63, and the supporting stages 62 and the supporting recesses 63, opposite each other, support the contacting portions 52. Namely, the supporting stages 62 and the supporting recesses 63, opposite each other, support the supporting portions 53 directly and the contacting portions 52 indirectly. Thereby each semiconductor silicon wafer is supported with a stronger force.

Owing to the above-mentioned structure, both small light semiconductor silicon wafers and large heavy semiconductor silicon wafer can be supported securely with optimum force.

Moreover, almost no dust is generated on each contacting point, so generation of dust and the like can be minimized.

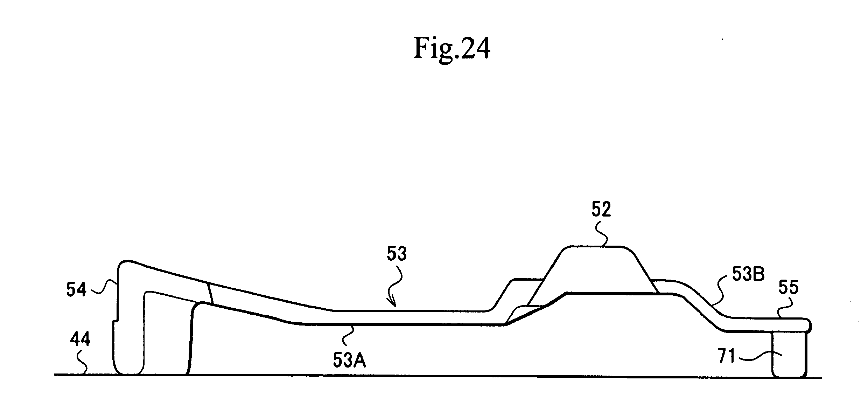

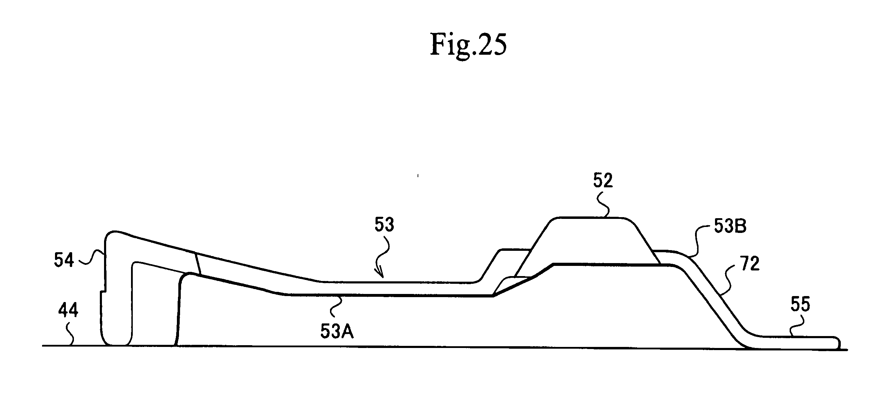

Since the thin plate supporting member 51 is formed as that each contacting portions 52 are aligned oppositely and alternately, the distance between each contacting portion 52 and supporting portion 53 of the thin plate supporting member 51 can be taken widely and then the thin plate supporting member 51 can be metal-molded easily. The structure of the metal mold can be simplified and then the metal mold can be made inexpensively. Thereby the production cost of the thin plate supporting member 51 can be kept low.
(1) Although two thin plate supporting members 51 are placed oppositely each other in the second example, one, two or more than three thin plate supporting members 51 can be also set according to the number of the semiconductor silicon wafers to store. The same function and effect as above-mentioned examples can be obtained in these case.
(2) Although the supporting stages 62 are placed on the inner side of the lid 44 to support the tip end of the supporting portions 53 in the second example, it is also available that supporting stage portions 71 are directly set on the caul plate portions 55 placed at the tip sides of the supporting portions 53 as shown in Fig. 24. And as shown in Fig. 25, it is available that the tip supporting portions 53B are elongated up to the inner side of the lid 44 to be lid supporters 72. The same function and effect as above-mentioned examples can be obtained in these case.
(3) Although semiconductor silicon wafers are taken as an example of thin plates in above-mentioned first and second examples, thin plates that can be affected by various kind of gas or fine-grain, such as glass plates, memory discs and the like, can be also adopted for the thin plate storage container of present invention.

## Claims

1. A thin plate storage container having a container body (2) to store a plurality of thin plates in condition that the inside of the container body (2) is kept clean, and a lid (3) to close and seal the inside of the container body (2), wherein the lid (3) is removable from the container body (2) to insert and pick up the thin plates, the container comprising:
a lid receptacle (7) placed on the opening part of the container body (2) to place the lid (3);
a plurality of lid supporters (10) placed on four edges of the lid receptacle (7) to support the lid (3); and
a plurality of contacting portions (16), with contacting plate portions (18) having outer sides, placed on the opposite part to the lid supporters (10) on the periphery of the lid (3) to contact with the lid supporters (10) and to support the lid (3),
**characterized in that**
the outer sides of the contacting plate portions (18) of the contacting portions (16) are formed as a flat contacting surface (18A), and the materials of both the lid supporters (10) and the contacting portions(16) are selected from a combination of materials that have low dust generating properties during friction, and wherein the contacting portion (16) comprises a fixing plate portion (17) inserted to and fixed on an engagement groove at a corner of the periphery of the lid (3), and the contacting plate portion (18) is held by the fixing plate and formed as a curve to cover the corner of the lid (3).

2. The thin plate storage container according to claim 1, wherein the lid supporters (10) include any one of polybutylene terephthalate resin, polyether ether keton resin, polyacetal resin, supermacromolecular polyethylene resin, nylon resin, and materials that polytetrafluor ethylene and/or carbon fiber is added to these five materials, and
the contacting portions (16) include any one of polybutylene terephthalate resin, polyether ether keton resin, polyacetal resin, supermacromolecular polyethylene resin, nylon resin, and materials that polytetrafluorethylene and/or carbon fiber is added to these five materials.

3. The thin plate storage container according to claim 1 or 2, wherein any one of polybutylene terephthalate resin, polyether ether keton resin, supermacromolecular polyethylene resin, and materials that polytetrafluorethylene and/or carbon fiber is added to these three materials is used for material of the lid supporters (10) and the contacting portions (16).

4. The thin plate storage container according to claim 1 or 2, wherein two combined materials selected from the group consisting of polybutylene terephthalate resin, polyether ether keton resin, supermacromolecular polyethylene resin, and materials that polytetrafluorethylene and/or carbon fiber is added to these three materials are used for material of the lid supporters (10) and the contacting portions (16).

## Patentansprüche

1. Ein Lagerbehälter für dünne Platten aufweisend einen Behälterkörper (2) zum Aufbewahren einer Vielzahl dünner Platten in einem Zustand, in dem das Innere des Behälterkörpers (2) rein gehalten wird, und einen Deckel (3), um das Innere des Behälterkörpers (2) zu verschließen und dichten, worin der Deckel (3) von dem Behälterkörper (2) für das Einsetzen und Aufnehmen der dünnen Platten abnehmbar ist, und der Behälter aufweist:
eine Deckelaufnahme (7), welche auf dem Öffnungsteil des Behälterkörpers (2) angeordnet ist, um den Deckel (3) anzubringen;
eine Vielzahl von Deckelträgern (10), die an vier Kanten der Deckelaufnahme (7) angeordnet sind, um den Deckel (3) zu stützen; und
eine Vielzahl von Kontaktierabschnitten (16) mit Kontaktier-Plattenabschnitten (18), die Außenseiten aufweisen, und die Kontaktierabschnitte (16) an dem Teil an dem Umfang des Deckels (3) angeordnet sind, welcher den Deckelträgern (10) gegenüberliegt, um mit den Deckelträgern (10) in Kontakt zu kommen und den Deckel (3) zu stützen,
**dadurch gekennzeichnet,**
**dass** die Außenseiten der Kontaktier-Plattenabschnitte (18) der Kontaktierabschnitte (16) als flache Kontaktierfläche (18A) ausgebildet sind, und die Materialien sowohl der Deckelträger (10) als auch der Kontaktierabschnitte (16) aus einer Kombination von Materialien ausgewählt sind, welche bei Reibung niedrige Staub verursachende Eigenschaften aufweisen, und worin der Kontaktierabschnitt (16) einen Halteplatten-Abschnitt (17) aufweist, der in eine Eingriffnut an einer Ecke des Umfangs des Deckels (3) eingesetzt und daran befestigt ist, und der Kontaktier-Plattenabschnitt (18) durch die Halteplatte gehalten ist und als eine Rundung geformt ist, um die Ecke des Deckels (3) zu bedecken.

2. Der Lagerbehälter für dünne Platten gemäß Anspruch 1, worin die Deckelträger (10) irgendeines von Polybutylenterephthalat-Harz , Polyetheretherketon-Harz, Polyacetal-Harz, supermakromolekulares (supermacromolecular) Polyethylen-Harz, Nylon-Harz enthalten, und jene Materialien Polytetrafluorethylen und/oder Kohlefaser zu jenen fünf Materialien hinzugefügt sind, und
die Kontaktierabschnitte (16) irgendeines von Polybutylenterephthalat-Harz , Polyetheretherketon-Harz, Polyacetal-Harz, supermakromolekulares (supermacromolecular) Polyethylen-Harz, Nylon-Harz enthalten, und jene Materialien Polytetrafluorethylen und/oder Kohlefaser zu jenen fünf Materialien hinzugefügt sind.

3. Der Lagerbehälter für dünne Platten gemäß Anspruch 1 oder 2, worin irgendeines von Polybutylenterephthalat-Harz , Polyetheretherketon-Harz, supermakromolekulares (supermacromolecular) Polyethylen-Harz, und jene Materialien Polytetrafluorethylen und/oder Kohlefaser zu diesen drei Materialien hinzugefügt, als Material der Deckelträger (10) und der Kontaktierabschnitte (16) verwendet ist.

4. Der Lagerbehälter für dünne Platten gemäß Anspruch 1 oder 2, worin zwei kombinierte Materialien ausgewählt aus der Polybutylenterephthalat-Harz , Polyetheretherketon-Harz und supermakromolekulares (supermacromolecular) Polyethylen-Harz umfassenden Gruppe, und jene Materialien Polytetrafluorethylen und/oder Kohlefaser zu diesen drei Materialien hinzugefügt, als Material der Deckelträger (10) und der Kontaktierabschnitte (16) verwendet ist.

## Revendications

1. Conteneur de stockage de plaques minces, présentant un corps de conteneur (2) pour stocker une pluralité de plaques minces, de sorte que l'intérieur du corps de conteneur (2) soit maintenu propre, et un couvercle (3) pour fermer et sceller l'intérieur du corps de conteneur (2), dans lequel le couvercle (3) peut être enlevé du corps de conteneur (2), pour insérer et prélever lesdites plaques minces, le récipient comprenant :
un réceptacle de couvercle (7) placé sur la partie d'ouverture du corps de conteneur (2) pour mettre en place le couvercle (3) ;
une pluralité de supports de couvercle (10) placés sur quatre bords du réceptacle de couvercle (7) afin de soutenir le couvercle (3) ; et
une pluralité de parties de contact (16), avec des parties formant plaques de contact (18) ayant des côtés extérieurs, placées sur la partie opposée aux supports de couvercle (10) sur la périphérie du couvercle (3), afin d'entrer en contact avec les supports de couvercle (10) et de soutenir le couvercle (3),
**caractérisé en ce que**
les côtés extérieurs des parties formant plaques de contact (18) des parties de contact (16) sont réalisés sous la forme d'une surface de contact plate (18A) et les matériaux à la fois des supports de couvercle (10) et des parties de contact (16) sont choisis à partir d'une combinaison de matériaux ayant des propriétés de faible génération de poussière pendant le frottement, la partie de contact (16) comprenant une partie formant plaque de fixation (17) insérée dans une cannelure de prise et fixée à celle-ci, à un coin de la périphérie du couvercle (3), et la partie formant plaque de contact (18) étant maintenue par la plaque de fixation et réalisée sous la forme d'une courbe pour couvrir le coin du couvercle (3).

2. Conteneur de stockage de plaques minces selon la revendication 1, dans lequel les supports de couvercle (10) comprennent n'importe quel matériau parmi une résine de polybutylène téréphtalate, une résine de polyéther éther cétone, une résine de polyacétal, une résine de polyéthylène supermacromoléculaire, une résine de nylon et les matériaux obtenus par addition d'un polytétrafluoroéthylène et/ou de fibre de carbone à ces cinq matériaux, et
les parties de contact (16) comprennent n'importe quel matériau parmi une résine de polybutylène téréphtalate, une résine de polyéther éther cétone, une résine de polyacétal, une résine de polyéthylène supermacromoléculaire, une résine de nylon et des matériaux obtenues par addition de polytétrafluoroéthylène et/ou de fibre de carbone à ces cinq matériaux.

3. Conteneur de stockage de plaques minces selon la revendication 1 ou 2, dans lequel l'un quelconque parmi une résine de polybutylène téréphtalate, une résine de polyéther éther cétone, une résine de polyéthylène supermacromoléculaire, et les matériaux obtenus par addition de polytétrafluoroéthylène et/ou de fibre de carbone à ces trois matériaux, est utilisé comme matériau pour les supports de couvercle (10) et les parties de contact (16).

4. Conteneur de stockage de plaques minces selon la revendication 1 ou 2, dans lequel deux matériaux combinés choisis dans le groupe constitué d'une résine de polybutylène téréphtalate, d'une résine de polyéther éther cétone, d'une résine de polyéthylène supermacromoléculaire, et de matériaux obtenus par addition de polytétrafluoroéthylène et/ou la fibre de carbone à ces trois matériaux, sont utilisés comme matériau pour les supports de couvercle (10) et les parties de contact (16).
